(19) Europäisches Patentamt
European Patent Office
Office européen des brevets

(11) **EP 4 246 164 A1**

(12) **EUROPEAN PATENT APPLICATION**

(43) Date of publication:
**20.09.2023 Bulletin 2023/38**

(21) Application number: **22020110.7**

(22) Date of filing: **14.03.2022**

(51) International Patent Classification (IPC):
**G01R 33/00** (2006.01)    **G01R 33/07** (2006.01)
**G01R 35/00** (2006.01)    G01R 33/02 (2006.01)

(52) Cooperative Patent Classification (CPC):
**G01R 33/0035; G01R 33/07; G01R 35/005;**
G01C 17/38; G01R 33/0017; G01R 33/0206

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Senis AG**
**6300 Zug (CH)**

(72) Inventors:
• **POPOVIC, Radivoje**
**6340 Zug (CH)**
• **BLAGOJEVIC, Marjan**
**18000 Nis (RS)**
• **STUCK, Alexander**
**5340 Wettingen (CH)**

(74) Representative: **Körner, Thomas Ottmar**
**freigutpartners gmbh**
**Gämsenstrasse 3**
**8006 Zürich (CH)**

(54) **METHOD FOR CALIBRATING A MAGNETIC SENSOR AND/OR A CALIBRATING MAGNET**

(57) A method for calibrating a magnetic sensor and/or a calibrating magnet, said sensor, when subjected to a magnetic field $\vec{B} = (B_x; B_y; B_z)^T$ exhibiting an output voltage $V$ governed by $V = V_0 + \vec{S} \cdot \vec{B}$, wherein $V_0$ denotes an offset voltage of the magnetic sensor, and $\vec{S} \cdot \vec{B}$ denotes a scalar product of a sensitivity vector $\vec{S} = (S_x; S_y; S_z)^T$ of the magnetic sensor and the magnetic field vector $\vec{B}$, the method comprising the steps of
a. measuring a first output voltage $V_1$ for a first orientation of the magnetic sensor relative to the magnetic field;
b. rotating the magnetic sensor relative to the magnetic field to assume $N$-1 further orientations, wherein $2 \leq N \in \mathbb{N}$ and each orientation is defined by a rotation matrix $\overset{\leftrightarrow}{R}_n$, wherein $\overset{\leftrightarrow}{R}_n \neq \overset{\leftrightarrow}{1}$ for $n \in \{2, ..., N\}$ and $\overset{\leftrightarrow}{R}_n \neq \overset{\leftrightarrow}{R}_m$ for $n \neq m \in \{2, ..., N\}$;
c. for each further orientation, measuring one further output voltage $V_n$, with $n \in \{2; ...; N\}$; and
d. solving a system of N equations $V_n = V_0 + (\overset{\leftrightarrow}{R}_n \vec{S}) \cdot \vec{B}$ with $\overset{\leftrightarrow}{R}_1 = \overset{\leftrightarrow}{1}$ for one or more of $V_0, S_x, S_y, S_z, B_x, B_y,$ and/or $B_z$.

Figure 2

EP 4 246 164 A1

**Description**

The invention pertains to the field of magnetic sensors, as, e.g., hall sensors. It relates to a method and apparatus for calibrating a magnetic sensor and/or a calibrating magnet.

The output voltage of a directional magnetic sensor, such as a Hall magnetic sensor, is given by the equation

$$V = V_0 + \vec{S} \cdot \vec{B} \qquad (1)$$

where $V_0$ denotes the offset voltage of the magnetic sensor, and $\vec{S} \cdot \vec{B}$ denotes the scalar (dot) product of the sensitivity vector of the Hall sensor $\vec{S}$ and the magnetic field vector $\vec{B}$ to which the magnetic sensor is exposed.

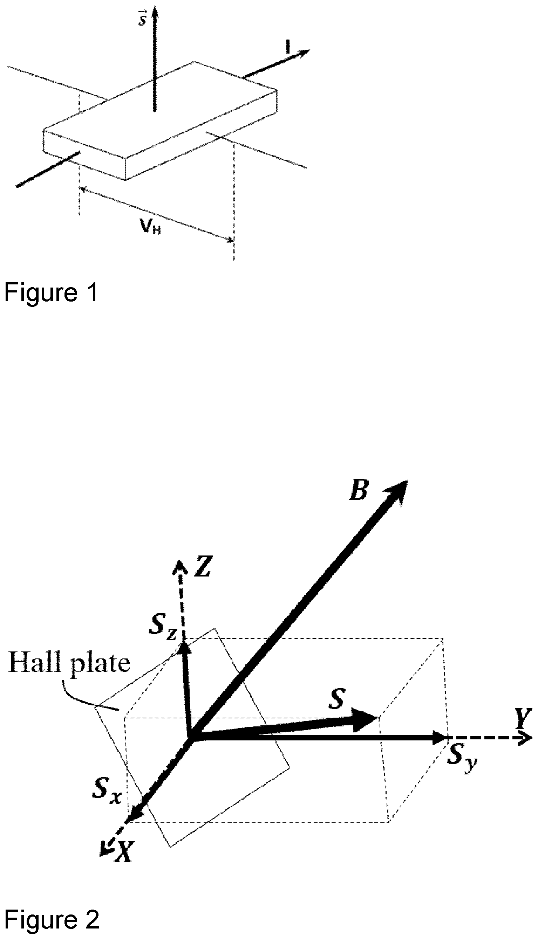

Figure 1 illustrates a Hall plate with associated magnetic sensitivity vector $\vec{S}$. The biasing current of the Hall plate is denoted by I, and $V_H$ the output voltage of the Hall plate.

The position and direction of the sensitivity vector of a directional magnetic sensor is determined by the structure and geometry of the sensor. For example, in the case of a Hall magnetic sensor based on a Hall plate, the sensitivity vector is positioned at the plate's center of symmetry and directed perpendicularly to the plate surface, as illustrated in Figure 1. In the case of the inductive magnetic sensor based on a solenoidal coil, the sensitivity vector is positioned at the solenoid's center of symmetry and directed along the coils axis.

The sensitivity vector of a directional magnetic sensor can be represented by its components as follows (see Figure 1):

$$\vec{S} = \hat{\imath} S_x + \hat{\jmath} S_y + \hat{k} S_z \qquad (2)$$

where $S_x$, $S_y$, $S_z$ denote the components of the vector $\vec{S}$ in a Cartesian coordinate system (R), and $\hat{\imath}, \hat{\jmath},$ and $\hat{k}$ are unit vectors parallel to the x, y and z axes, respectively, of the coordinate system.

Figure 2 shows an illustration of the vector $\vec{S}$ and its components of a Hall plate exposed to a magnetic field vector $\vec{B}$.

Similarly, the vector of the magnetic field can be represented by its components in the same coordinate system R:

$$\vec{B} = \hat{\imath} B_x + \hat{\jmath} B_y + \hat{k} B_z \qquad (3)$$

Alternatively, the vector $\vec{B}$ can be represented as follows:

$$\vec{B} = B\left(\hat{\imath} C_x + \hat{\jmath} C_y + \hat{k} C_z\right) \qquad (4)$$

where $B$ denotes the modulus of the vector $\vec{B}$, and $C_x$, $C_y$ and $C_z$ are the directional cosines of the vector $\vec{B}$ in the coordinate system R.

Using expressions (2) - (4), equation (1) can be re-written in the following forms:

$$V = V_0 + S_x B_x + S_y B_y + S_z B_z \qquad (5)$$

or

$$V = V_0 + B(S_x C_x + S_y C_y + S_z C_z) \qquad (6)$$

In practical applications of a directional magnetic sensor, the parameters $V_0$, $S_x$, $S_y$ and $S_z$ must be known with high-enough accuracy. The process of the measurement of these parameters is called the calibration of a directional magnetic sensor.

Similarly, in practical applications of a magnet used for magnetic measurements, such as the calibration of magnetic sensors, either the parameters $B_x$, $B_y$ and $B_z$, or $B$, $C_x$, $C_y$ and $C_z$ must be known with high-enough accuracy. The process of the measurement of these parameters is called the calibration of a magnet.

The standard method of the measurement of the offset voltage of a magnetic sensor is to place the sensor in a so-called zero-gauss chamber (ZGC) and then to measure its output voltage. Since a zero-gauss chamber is made of a ferromagnetic material of high permeability, it is assumed that it shields the sensor from the environmental magnetic field; then, according to Eq. (1), assuming $\vec{B} = 0$, the output voltage of the sensor ($V$) is equal to the offset voltage, $V = Vo$. However, ZGC might not be perfect, or it might be accidentally magnetized, so therein might be $\vec{B} \neq 0$, and the offset measurement will be incorrect.

The conventional method of the measurement of the magnetic sensitivity of a magnetic sensor comprises the measurements the output voltage of the sensor, which is exposed to a known magnetic field vector. For example, according to the European patent application publication EP 1518131 A1, the magnetic sensitivity of a Hall magnetic sensor is measured by continuously changing and measuring the two angular positions of the Hall element in a known magnetic field. The measurement results are interpreted using spherical harmonics.

Typically, the modulus of the magnetic field vector, which is used for the calibration, is measured by an NMR-teslameter (NMR: nuclear magnetic resonance); and the angular position of this vector is estimated based on the geometry and material properties of the source of the magnetic field (calibrating magnet). However, such an estimation of the angular position of the magnetic field vector is subject to substantial errors, due to the fact that the model of the geometry of the magnetic source is simplified; and the material properties of the calibrating magnet are only approximately known and, due to the hysteresis effect, they may depend on the operation pre-history of the magnet.

Alternatively, the angular position of the magnetic field vector of the calibrating magnet is determined by the measurement using a previously calibrated directional magnetic sensor. In this case arises the question of the accuracy of this previous calibration (what was first - calibration of the magnet or the calibration of the magnetic sensor - chicken or egg?).

In summary, according to the previous art,

- The calibration of a directional magnetic sensor can be performed only in a magnetic field, which is either equal to zero (for offset calibration), or it has precisely known both the modulus and the angular position (for sensitivity calibration). It is difficult to meat both of these conditions.
- The calibration of a calibrating magnet relies either on some unreliable assumptions or on unreliable results of a previous calibration.

Therefore, it would be desirable to find new methods for the calibration of a directional magnetic sensor and of the calibration of a magnet, which is more accurate and easier to perform than the previously known corresponding calibration methods.

SUMMARY OF THE INVENTION

The above objective and other objectives are solved by a method and an apparatus in accordance with the independent claims. Preferred embodiments and/or variations of the invention are presented in dependent claims.

A method for calibrating a magnetic sensor and/or a calibrating magnet in accordance with an aspect of the invention as hereinafter claimed may comprise the steps of claim 1 below.

A method for calibrating a magnetic sensor and/or a calibrating magnet, wherein said sensor, when subjected to a magnetic field $\vec{B} = (B_x; B_y; B_z)^T$, exhibits an output voltage $V$ governed by $V = V_0 + \vec{S} \cdot \vec{B}$, wherein $V_0$ denotes an offset voltage of the magnetic sensor, and $\vec{S} \cdot \vec{B}$ denotes a scalar product of a sensitivity vector $\vec{S} = (S_x; S_y; S_z)^T$ of the magnetic sensor and the magnetic field vector $\vec{B}$, may, in accordance with the invention, comprise the steps of

    a. measuring a first output voltage $V_1$, for a first orientation of the magnetic sensor relative to the magnetic field;
    b. rotating the magnetic sensor, in particular relative to the magnetic field, to assume $N$-1 further orientations, wherein $2 \leq N \in \mathbb{N}$ and each orientation is defined by a rotation matrix $\vec{\vec{R}}_n$, wherein $\vec{\vec{R}}_n \neq \vec{\vec{1}}$ for $n \in \{2, ..., N\}$ and $\vec{\vec{R}}_n \neq \vec{\vec{R}}_m$ for $n \neq m \in \{2, ..., N\}$;
    c. for each further orientation, measuring one further output voltage $V_n$, with $n \in \{2; ... ; N\}$; and
    d. solving a system of N equations $V_n = V_0 + (\vec{\vec{R}}_n \vec{S}) \cdot \vec{B}$ with $\vec{\vec{R}}_1 = 1$ for one or more of $V_0, S_x, S_y, S_z, B_x, B_y,$ and/or $B_z$.

The output voltage $V$ will thus in general depend on and/or vary with the orientation of the magnetic sensor (for reasons of brevity, also referred to as sensor in what follows), in particular the orientation relative to the magnetic field, and will change when either the sensor or the magnetic field, in particular a magnet generating the electric field, is rotated. The orientation may also be referred to as the position in what follows. The sensor may in particular be a Hall sensor, in particular a Hall plate.

The offset voltage $V_0$ is, in general, specific for an individual sensor, but may slowly change over time. The offset voltage may also depend on other parameters, in particular a temperature of the sensor, etc. Two different sensors will in general have different offset voltages.

The magnetic field $\vec{B} = (B_x; B_y; B_z)$ may in particular be generated by the calibrating magnet. The magnetic field $\vec{B}$ may also result from a superposition a calibration field generated by the calibration magnet, and one or more further magnetic field, in particular a (local) magnetic field of the earth.

In order to rotate the magnetic sensor relative to the magnetic field, the magnetic sensor may be rotated in a reference coordinate system, in particular by an angle $\alpha$ about an axis defined by and/or parallel to a vector $\vec{D}$ with $\|\vec{D}\| \neq 0$, said vector being defined with respect to the reference coordinate system. More generally, the magnetic sensor may be subjected to a rotation $\overleftrightarrow{R}$; wherein $\overleftrightarrow{R} \pm \overleftrightarrow{1}$ is a matrix characterizing a rotation with respect to the reference coordinate system. Alternatively, the magnetic sensor may remain stationary, while the magnetic field may be subjected to an inverse rotation, in particular to a rotation by $-\alpha$ about the axis defined by and/or parallel to the vector $\vec{D}$, or more generally, to a rotation defined by $\overleftrightarrow{R^{-1}}$, wherein $\overleftrightarrow{R^{-1}} = \overleftrightarrow{R^T}$. The magnetic field may, in particular, be rotated by rotating a magnet generating the magnetic field $\vec{B} = (B_x; B_y; B_z)^T$, in particular the calibrating magnet.

In embodiments, both the magnetic sensor and the magnetic field may be rotated subsequently and/or alternatingly, in particular several times each, to assume the $N$-1 further (relative) orientations, wherein at least one relative orientation may be assumed repeatedly. This may allow for higher calibration accuracy in determining

The reference coordinate system may in particular be a static coordinate system which remains fixed and/or stationary when the magnetic sensor and/or the magnetic field is rotated and may in particular be defined by laboratory walls and floor, and/or edges and/or corners between the latter.

Briefly, a method in accordance with the invention as hereinafter claimed for calibrations of a directional magnetic field sensor (Sensor) and/or of a magnet used for the calibration (Magnet) may comprise one or more, in particular all, of the following steps:

- Sensor is placed in the magnetic field of Magnet in a finite number ($N$) of angular positions (Position) and/or orientations with respect to a coordinate system of Magnet;
- At each of these Positions, the output voltage of Sensor (Voltage) is measured;
- Each measured Voltage is substituted in the corresponding equation, which, for the given Position, relates the measured Voltage to the components the sensitivity vector of Sensor and the components of the magnetic field of Magnet; in this way, a system of N equations is obtained;
- The solution of the said system of equations gives the values of the offset, and / or of the components of the magnetic sensitivity vector of Sensor, and / or of the components of the magnetic field vector of Magnet.

Preferably, positions and/or orientations are chosen so that the said system of equations is analytically solvable.

The sensor may be comprised by or comprise electric and/or electronic circuitry (to be referred to as circuitry in what follows). The circuitry may comprise wiring, printed circuits etc.; and/or passive electric elements like resistors, diodes, capacitors, inductors, etc. The circuitry may comprise an electric power source and/or storage, in particular a (rechargeable) battery and/or a capacitor. The circuitry may comprise terminals and/or wireless connection means (e.g. RFID or similar), in particular for connecting and/or interfacing the sensor with external electric and/or electronic measurement equipment, e.g. for measurement data acquisition, processing, analysis and/or representation. The circuitry may comprise or represent a logic circuit. The circuitry may comprise an integrated circuit, in particular a general purpose central processing unit (CPU), a microcontroller, a reduced instruction set computer (RISC) processor, an application specific integrated circuit (ASIC), a programmable logic circuit (PLC), a field programmable gate array (FPGA), and/or any other circuit or processing device. The circuitry may comprise a non-volatile memory, in particular EPROM or EEPROM. The (actual) sensor together with the circuitry may constitute a sensor unit.

The sensor unit comprising the sensor may be comprised by or comprise an enclosure, e.g. a housing. The enclosure may be formed integrally with the sensor unit, e.g. by casting the unit into a thermoplastic material. The enclosure may constitute a package for the sensor, also referred to as the sensor's package.

$S_x$, $S_y$, $S_z$ are preferably determined with respect to a, in particular cartesian, natural coordinate system of the sensor and/or the sensor's package. Such a coordinate system may be defined by edges of the sensor and/or the sensor package, wherein linearly independent, preferably orthogonal, unit vectors $\hat{i}$, $\hat{j}$, and $\hat{k}$ may be selected to coincide with edges and/or point in directions defined by edges of the sensor and/or the sensor's package. In particular, where the sensor and/or the sensor's package has the shape of a, preferably rectangular, cuboid, unit vectors $\hat{i}$, $\hat{j}$, and $\hat{k}$ may be selected to point along the respective directions of three edges joined at one corner of said cuboid, and/or extend perpendicular to faces defining the cuboid.

Alternatively, $S_x$, $S_y$, $S_z$ may be determined with respect to an arbitrary coordinate system in a first step, and components $S'_x$, $S'_y$, and $S'_z$; of sensitivity vector $\vec{S}$ may subsequently be determined by transformation to a natural coordinate system of the sensor and/or the sensor's package with unit vectors $\hat{i}'$, $\hat{j}'$, and $\hat{k}'$ as described above.

Sensitivity vector components $S_x$, $S_y$, $S_z$ and/or $S'_x$, $S'_y$, and $S'_z$ may subsequently be stored in non-volatile memory, in particular EPROM or EEPROM comprised by the sensor unit comprising the sensor as exemplary described above. This allows for efficient and error-free determination of vector magnetic fields, comprising in particular their correct orientation is space, by means of the calibrated sensor.

The present invention thus has, inter alia, the following advantages:

First, overcoming of the prejudice of the previous art - that the calibration of a directional magnetic sensor can be performed only in a magnetic field, which is either non-existent (for offset calibration), or it has precisely known both the modulus and the angular position (for sensitivity calibration). In contrary, according to the present invention,

- The offset can be measured in the presence of an arbitrary and unknown magnetic field;
- The sensitivity vector can be determined by exposing the magnetic sensor to a magnetic field vector, of which only the modulus is known a priory, whereas its angular position is irrelevant.

The only relevant condition concerning the magnetic field is that this field stays constant during the measurements.

Second, the proposed method also enables the measurement of the angular position of the magnetic field vector of the magnet used for the calibration, without relying on the geometry, material properties, nor on a previous calibration of a magnetometer.

DETAILED DESCRIPTION OF EXEMPLARY EMBODIMENTS

The subject matter of the invention will be explained with respect to further optional detail in the following text with reference to further exemplary embodiments which are illustrated in the attached drawings.

In the following, the following notations will be used:

- The directional magnetic sensor under test will be referred to in short as Sensor;
- The source of the magnetic field, which is present during the measurement of the Sensor's offset, or, which is used to measure the sensitivity vector of Sensor, will be referred to in as Magnet;
- The coordinate system of Sensor, defined by some of the planes and/or edges of the Sensor's package, will be denoted by Rs.
- The coordinate system of Magnet, defined by the some planes and/or edges of the Magnet's configuration will be denoted by Rm.
- The angular position of Sensor with respect to the coordinate system Rm, or vice versa, the angular position of Magnet with respect to the coordinate system Rs, will be referred to either as Position or Direction; If not stated otherwise, it will be assumed that Position is defined with reference to Rm.
- The number of Positions will be denoted by N; N is an integer number.
- The output voltage of Sensor will be referred to as Voltage.

Calibration of a Sensor and Magnet by a single series of steps

According to the present invention, the measurement of all 7 calibrating parameters of Sensor ($V_0$, $S_x$, $S_y$ and $S_z$) and of Magnet ($C_x$, $C_y$ and $C_z$) can be made by performing a single process comprising the following steps:

A. The module of the magnetic field of Magnet is measured by an adequate magnetometer, such as NMR teslameter;
B. Sensor is placed in the magnetic field of Magnet in at least 6 Positions; thereby Positions are chosen in such a way, that the system of equations described in Step D below contains 7 independent equations;
C. At each of these Positions, the output voltage of Sensor (Voltage) is measured;
D. Each measured Voltage is substituted in the equation (5) or (6), which, for the given Position, relates the measured Voltage to the Sensor's offset, the components of the sensitivity vector of Sensor, and the components of the magnetic field of Magnet; in this way, a system of equations is obtained, which comprises 7 independent equations (one of which is a mathematical identity - see Eq.(37a) below);
E. The said system of equations is solved either analytically or numerically. The solution of this system of equations gives the values of the offset voltage, and / or of the components of the magnetic sensitivity vector of Sensor, and / or the components or the directional cosines of the magnetic field vector of Magnet.

However, in praxis, it is often more convenient not to calibrate all 7 parameters at once; instead, it is often more convenient to split the above calibration process into a few separate sub-processes.

For example, it is convenient to perform the calibrations of Sensor's offset and the calibration of Sensor's sensitivity and Magnet's field direction in two separate sub-processes. The main reasons for doing so are the following:

- Very often, the offset of a magnetic sensor exhibits a substantial drift, whereas the other Sensor's and Magnet's characteristics much more stable. Therefore, the offset must be calibrated more frequently than the other characteristics. For this reason, it is worthwhile to perform the offset calibration by a simplified version of the above process chain.
- The convenient strengths of the magnetic field for the offset and sensitivity calibration is often very different; for offset, $B \leq 0.1$ mT, whereas for Sensor's sensitivity and Magnet's calibrations, usually $B \geq 100$mT.

Another example is the calibration of Sensor's sensitivity in a separate sub-process: once a Magnet is calibrated by the complete process, the angular position of its magnetic field vector ( $C_x$, $C_y$ and $C_z$) will be known. Then, many Sensors can be calibrated in this Magnet by a simplified version of the above process chain.

Similarly, once a Sensor is calibrated by the complete process or by two simplified processes, it can be used to calibrate several Magnets by a simplified version of the above process chain.

Therefore, the preferred implementation of the present invention is to perform it in two, three or more independent sub-processes. If the calibration process is split into sub-processes, then the minimum number of Positions in each of the sub-processes shall be equal to the number of unknown parameters that are treated (cancelled out or to be determined) in each of the sub-processes. Below are described a few examples of such preferred calibration sub-processes.

Measurement of Sensor's offset voltage

According to the present invention, one can measure only the offset voltage of a Sensor, even in the presence of an unknown but constant magnetic field, by the following sub-process:

A. Fails - not needed.
B. Sensor is placed in the magnetic field of Magnet in at least 4 Positions; thereby Positions are chosen in such a way, that the system of equations described in Step D below contains 4 independent equations;
C. At each of these Positions, the output voltage of Sensor (Voltage) is measured;
D. Each measured Voltage is substituted in the equation (5) or (6), which, for the given Position, relates the measured Voltage to the Sensor's offset and the components of the sensitivity vector of Sensor and the components of the magnetic field of Magnet; in this way, a system of equations is obtained, which comprises 4 independent equations;
E. The said system of equations is solved either analytically or numerically. The solution of the said system of equations gives the value of the offset voltage.

Preferably, the said Positions are predetermined in such a way, that the said equations make a system of equations, in which all the terms containing the components of the Sensor's sensitivity vector and the components of the magnetic field can be mutually cancelled out. Consequently, the said system of equations can be solved analytically, by reducing it to a single equation, which gives the sought offset voltage of Sensor.

For example, if the offset voltage of a Sensor is measured in the presence of the Earth's magnetic field, i.e. Magnet is Earth, then Sensor shall be placed in the said series of 4 Positions with respect to a stationary laboratory coordinate system.

Preferably, the first of the said sensor's Positions shall be chosen so that the coordinate axes of Sensor's coordinate system Rs are parallel with the corresponding coordinate axes of Magnet's coordinate system Rm; and the other Sensor's Positions shall be realized by rotations of Sensor around one of the magnet's coordinate axis for 90° or 180°.

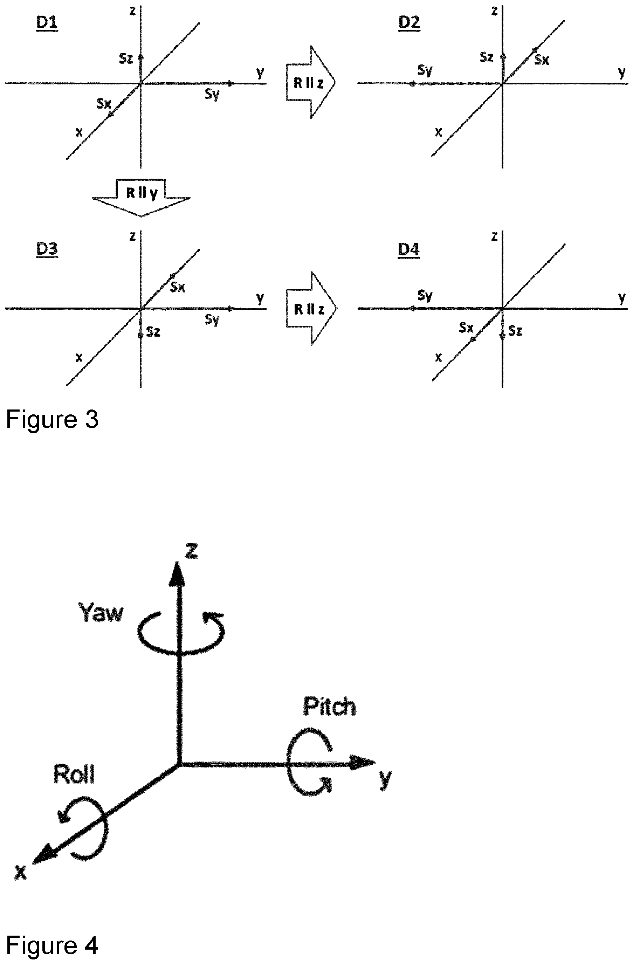

Figure 3 shows an example of the four preferable Sensor Positions with respect to the coordinate system of a Magnet. For each of the four Sensor Positions the components of its sensitivity vector, $S_x$, $S_y$, and $S_z$, are shown. In the first Position (Direction) D1 the respective coordinate axes of the Sensor and Magnet's coordinate systems are parallel. R ‖ z and R ‖ y denote the rotations around the z and y-axis, respectively. Direction D2 is obtained from D1 by turning Sensor for 180° around the z-axis. The direction D3 is obtained from D1 by turning Sensor for 180° around the y-axis. The direction D4 is obtained from D3 by turning Sensor for 180° around the z-axis. A dashed arrow means that the corresponding vector has the negative sign.

Figure 3 illustrates the components of the Sensor's Sensitivity vector in a set of four sensor Directions, D1 to D4, that are convenient for the offset measurement. The direction D1 is the same as that shown in Figure 2. The vector of a magnetic field is not shown.

For the four Directions of Sensor shown in Figure 3, one can re-write Eq. (5) as follows:

$$D1: \quad V_1 = V_0 + S_x \cdot B_x + S_y \cdot B_y + S_z \cdot B_z \qquad (7)$$

$$D2: \quad V_2 = V_0 - S_x \cdot B_x - S_y \cdot B_y + S_z \cdot B_z \qquad (8)$$

$$D3: \quad V_3 = V_0 - S_x \cdot B_x + S_y \cdot B_y - S_z \cdot B_z \qquad (9)$$

$$D4: \quad V_4 = V_0 + S_x \cdot B_x - S_y \cdot B_y - S_z \cdot B_z \qquad (10)$$

By summing Eqs. (7) to (11), we obtain

$$V_0 = (V_1 + V_2 + V_3 + V_4)/4 \qquad (11)$$

This Eq. (11) gives the value of the sought offset voltage of Sensor.

Figure 3 and Eqs. (7) to (10) refer to the four Sensor Positions, which are obtained, one from the other, by rotations for 180° around z and y axis. Similar set of equations can be generated by other sets of Directions that are based on rotations for 180° around any two of the three coordinate axis. In each particular case of offset measurement, one can choose the most convenient set of at least four sensor Directions, provided that in the sum of the four corresponding equations similar to Eqs. (7) to (10), the magnetic field does not appear, as it does not appear in Eq. (11).

In a special case, when the component, which is parallel with the rotation axis, of either the vector $\vec{S}$ or of the vector $\vec{B}$, or of both, is equal to zero, the above offset calibration sub-process can be further simplified. For example, if above Sz = 0, and/or Bz = 0, then the offset measurement can be performed with only 2 Positions, namely D1 and D2. In this case, the solution of the system of the equations (7) and (8) is

$$Vo = (V1 + V2) / 2 \qquad (11a)$$

By performing the above offset measurement several times, preferably with different sets of the four Directions, and subsequently averaging the obtained result, one can decrease the error of the measured offset.

Therefore, by applying the present method, we can measure the offset voltage of a directional magnetic sensor in the presence of an unknown, or only partially known magnetic field. The only condition concerning the magnetic field is that it stays constant during at least four successive measurements described above.

Measurement of Sensor's sensitivity vector and the direction of Magnet's magnetic field vector

Ones the offset voltage is measured as described above, it can be cancelled in the Sensor output voltage. Then the equation (6) can be re-written as follows:

$$V/B = S_x C_x + S_y C_y + S_z C_z \qquad (12)$$

wherein $V$ may correspond to $V - V_0$ as previously used, and further, by introducing the symbol

$$S_i = V/B \qquad (13)$$

$$S_i = S_x C_x + S_y C_y + S_z C_z \qquad (14)$$

The ratio ($V/B$) in (13) is called the "actual sensitivity" of the Sensor, and is denoted by $S_i$ ($i$ is an index). We use the attribute "actual sensitivity" because the value of $S_i$ depends on the actual Position of the vector $\vec{S}$.

In equation (14), only the actual sensitivity $S_i$ can be measured directly, while the other 6 parameters on the right side of the equation are unknown. The present invention makes it possible to find these unknown parameters in the following way:

A. The module of the magnetic field of Magnet is measured by an adequate magnetometer, such as NMR teslameter;
B. Sensor is placed in the magnetic field of Magnet in at least 5 Positions; thereby Positions are chosen in such a way, that the system of equations described in Step D below contains 6 independent equations;
C. At each of these Positions, the output voltage of Sensor (Voltage) is measured;
D. Each measured Voltage is substituted in the equation (5) or (6), which, for the given Position, relates the measured Voltage to the components of the sensitivity vector of Sensor and the components of the magnetic field of Magnet; in this way, a system of equations is obtained, which comprises 6 independent equations;
E. The said system of equations is solved either analytically or numerically. The solution of the said system of equations gives the values of the components of the magnetic sensitivity vector of Sensor, and / or the components or the directional cosines of the magnetic field vector of Magnet.

The expression "independent equations" as introduced above may be understood such that that none of the equations can be derived algebraically from the others.

Preferably, the said Positions are predetermined in such a way, that the said equations make a system of equations, in which some of the terms containing the components of the magnetic field can be mutually cancelled out.

Consequently, the said system of equations can be simplified, so that it becomes analytically solvable. The solution of this system of equations gives the sought values of the components of the sensitivity vector of sensor $\vec{S}$ and the values of the components of the magnetic field vector $\vec{B}$.

For example, if Magnet is a large stationary electromagnet, then Sensor shall be placed in the said series of the positions, or directions, with respect to the electromagnet's coordinate system. Alternatively, if Magnet is small permanent magnet, or a system of such magnets, then Magnet may be placed in the said series of the positions, or directions, with respect to the Sensors's coordinate system.

Preferably, the first of the said mutual positions of the magnet and the magnetic sensor shall be chosen so that the coordinate axes of the Sensor's coordinate system Rs are parallel with the corresponding coordinate axes of the Magnet's coordinate system Rm. The other Sensor's positions can be realized by rotations of Sensor around one of the Magnet's coordinate axis for 90° or 180°. Alternatively, the other Magnet's positions can be realized by rotations of Magnet around one of the Sensor's coordinate axis for 90° or 180°.

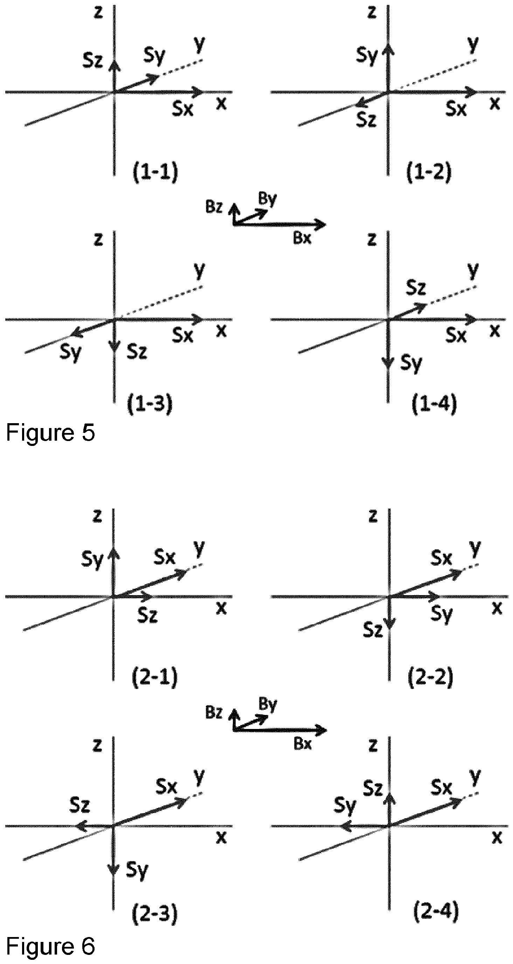

Figures 5 to 7 show an example of the set of 12 Sensor's positions with respect to the coordinate system of Magnet, which meats the above criteria. For each of the 12 Sensor's directions shown are the components of the magnetic field, $B_x$, $B_y$ and $B_z$, and of the Sensor's sensitivity vector, $S_x$, $S_y$, and $S_z$. As it will be seen later, the 12 positions are more than twice as much as necessary; but a measurement with more than the minimum number of the positions, which is here 5, helps increase the accuracy of the measurement.

1) Measurements with $\underline{S_{x'} \parallel X}$

In Figure 5, the direction 1-1, the respective coordinate axes of the Sensor's and of the Magnet's coordinate systems are parallel. The direction 1-2 is obtained from 1-1 by turning clockwise Sensor for 90° around the common z-axis. The direction 1-3 is obtained from 1-2 also by turning Sensor clockwise for 90° around the y-axis. And the direction 1-4 is obtained from 1-3 also by turning Sensor clockwise for 90° around the y-axis.

In each of these positions, the output voltage of Sensor $V$ and the modulus of the magnetic field vector $B$ of the Magnet are measured simultaneously, and $S_i$ is calculated according to equation (13). According to Figure 5 and equation (14), Si for the 4 Sensor positions shown is given by the following expressions:

$$1\text{-}1: \quad S_{11} = S_x C_x + S_y C_y + S_z C_z \quad\quad\quad (15)$$

$$1\text{-}2: \quad S_{12} = S_x C_x - S_z C_y + S_y C_z \quad\quad\quad (16)$$

$$1\text{-}3: \quad S_{13} = S_x C_x - S_y C_y - S_z C_z \quad\quad\quad (17)$$

$$1\text{-}4: \quad S_{14} = S_x C_x + S_z C_y - S_y C_z \quad\quad\quad (18)$$

By adding equations (15) and (17) we get

$$S_{11} + S_{13} = 2S_x C_x \tag{19}$$

Similarly, by adding equations (16) and (18) we get

$$S_{12} + S_{14} = 2S_x C_x \tag{20}$$

The last two equations are redundant, which means that in principle it is sufficient to perform only two of the above measurements, not four; but the use of four measurements increases the accuracy of the procedure, so, for example, we further calculate with 4 measurements. By adding equations (19) and (20) is obtained

$$S_{11} + S_{12} + S_{13} + S_{14} = S_{1x} = 4S_x C_x \tag{21}$$

Figure 5 illustrates the first sub-set of the mutual Magnet-Sensor positions for the measurements of the Sensor's relative sensitivities with $S_x \parallel X$.

Figure 6 illustrates the second sub-set of the mutual Magnet-Sensor positions for the measurements of the Sensor's relative sensitivities with $S_x \parallel Y$.

2) Measurements with $S_x$, II Y

In Figure 6, the direction 2-1, the X axis of Sensor is parallel with the Y axis of Magnet, Y axis of the Sensor is parallel with the Z axis of Magnet, and the Z axis of Sensor is parallel with the X axis of Magnet. The directions 2-2, 2-3 and 2-3 are obtained by the Sensor rotations for 90° around the Y axis of Magnet, analogously to the rotations around the X axis shown in Figure 5.

According to Figure 4, $S_i$ for the 4 probe positions shown is given by the following expressions:

$$2\text{-}1: \quad S_{21} = S_z C_x + S_x C_y + S_y C_z \tag{22}$$

$$2\text{-}2: \quad S_{22} = S_y C_x + S_x C_y - S_z C_z \tag{23}$$

$$2\text{-}3: \quad S_{23} = -S_z C_x + S_x C_y - S_y C_z \tag{24}$$

$$2\text{-}4: \quad S_{24} = -S_y C_x + S_x C_y + S_z C_z \tag{25}$$

By adding equations (22) and (24) we get

$$S_{21} + S_{23} = 2S_x C_y \tag{26}$$

Similarly, by adding equations (23) and (25) we get

$$S_{22} + S_{24} = 2S_x C_y \tag{27}$$

Here, the last two equations are also redundant, but, as above, we further calculate with both of them. Addition (22) and (25) gives:

$$S_{21} + S_{22} + S_{23} + S_{24} = S_{2x} = 4S_x C_y \tag{28}$$

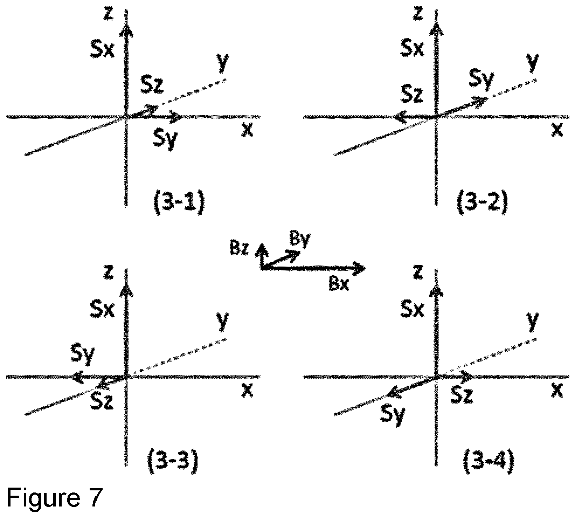

Figure 7 illustrates the third sub-set of the mutual Magnet-Sensor positions for the measurements of the Sensor's relative sensitivities with $S_x \parallel Z$.

3) Measurements with $S_{x'} \parallel Z$

In Figure 7, the direction 3-1, the X axis of Sensor is parallel with the Z axis of Magnet, Y axis of Sensor is parallel with the X axis of Magnet, and the Z axis of Sensor is parallel with the Y axis of Magnet. The directions 3-2, 3-3 and 3-3 are obtained by Sensor rotations for 90° around the Z axis of Magnet, analoguesly to the rotations around the X axis shown in Figure 5 and the rotations around the Y axis shown in Figure 6.

According to Figure 7, $S_i$ for the 4 probe positions shown is given by the following expressions:

$$3\text{-}1: \quad S_{31} = S_y C_x + S_z C_y + S_x C_z \tag{29}$$

$$3\text{-}2: \quad S_{32} = -S_z C_x + S_y C_y + S_x C_z \tag{30}$$

$$3\text{-}3: \quad S_{33} = -S_y C_x - S_z C_y + S_x C_z \tag{31}$$

$$3\text{-}4: \quad S_{34} = S_z C_x - S_y C_y + S_x C_z \tag{32}$$

By adding equations (29) and (31) we get

$$S_{31} + S_{33} = 2S_x C_z \tag{33}$$

Similarly, by adding equations (30) and (32) we get

$$S_{32} + S_{34} = 2S_x C_z \tag{34}$$

Also here the two equations are redundant, but, as above, we calculate with both. By adding (33) and (34) it is obtained

$$S_{31} + S_{32} + S_{33} + S_{34} = S_{3x} = 4S_x C_z \tag{35}$$

Calculating the component $S_{x'}$

Equations (21), (28) and (35) can be written as follows:

$$\begin{aligned} S_{1x}/(4S_x) &= C_x \\ S_{2x}/(4S_x) &= C_y \\ S_{3x}/(4S_x) &= C_z \end{aligned} \tag{36}$$

If both sides of these equations are squared and then these three equations are added together, we get

$$(S_{1x}/4S_x)^2 + (S_{2x}/4S_x)^2 + (S_{3x}/4S_x)^2 = 1 \tag{37}$$

because

$$C_x^2 + C_y^2 + C_z^2 = 1 \tag{37a}$$

(the sum of the squares of the directional cosines of vector $\vec{B}$). From equation (37) it is possible to calculate the component x of the probe sensitivity,

$$S_x = (1/4)\sqrt{S_{1x}^2 + S_{2x}^2 + S_{3x}^2} \tag{38}$$

where are S1x, S2x and S3x are the measured values of the generalized actual sensitivities of the Sensor, which are defined by equations (21), (28) and (35).

Calculating the cosines of the direction of vector $\vec{B}$

From equations (36) and (38) the cosines of the direction of the magnetic field vector are calculated directly:

$$\begin{aligned}
C_x &= S_{1x}/(4S_x) \\
C_y &= S_{2x}/(4S_x) \\
C_z &= S_{3x}/(4S_x)
\end{aligned} \tag{39}$$

Calculating the components $S_y$ and $S_z$

We will use equations (22)-(25) and (29)-(32). Subtracting equation (24) from equation (22) gives:

$$S_{21} - S_{23} = 2S_z C_x + 2S_y C_z \tag{40}$$

Subtracting equation (25) from equation (23) gives:

$$S_{22} - S_{24} = 2S_y C_x - 2S_z C_z \tag{41}$$

Similarly, subtracting equation (31) from equation (29) and (32) from (30), respectively, gives

$$S_{31} - S_{33} = 2S_y C_x + 2S_z C_y \tag{42}$$

$$S_{32} - S_{34} = -2S_z C_x + 2S_y C_y \tag{43}$$

Subtracting equations (43) from (40) and adding equations (41) and (42) forms the following system of equations:

$$S_{22} - S_{24} + S_{31} - S_{33} = 4S_y C_x + 2S_z(C_y - C_z) \tag{44}$$

$$S_{21} - S_{23} - S_{32} + S_{34} = 4S_z C_x + 2S_y(C_y - C_z) \tag{45}$$

The solution of this system of equations is:

$$S_y = \frac{2(S_{22} - S_{24} + S_{31} - S_{33}) + (C_z - C_y)(S_{21} - S_{23} - S_{32} + S_{34})}{8C_x^2 + 2C_y^2 - 4C_y C_z + 2C_z^2} \tag{46}$$

$$S_z = \frac{2C_x(S_{21} - S_{23} + S_{34} - S_{32}) + (C_z - C_y)(S_{24} - S_{22} + S_{33} - S_{31})}{2\left(4C_x^2 + C_y^2 - 2C_y C_z + C_z^2\right)} \tag{47}$$

$S_y$ and $S_z$ are the required components of the vector $\vec{S}$.

Measurement of the Sensor's magnetic sensitivity vector when the field vector of the Magnet is known

Once the cosines of the direction of the magnetic field vector of the used Magnet are determined as described above in the second calibration sub-process, a simplified procedure with at least 3 Positions can be used to measure only the sensitivity vector of other Sensors.

For example: The Sensor is positioned so that its sensitivity components $S_x$, $S_y$ and $S_z$ are, one after the other, parallel to the main component of the vector $\vec{B}$, for example, parallel to $B_x$. This corresponds to one position from Figures 5, 6 and 7, for example positions (1-1), (2-1) and (3-1).

We rewrite three equations 15, 22, and 29 from above:

$$1\text{-}1: \quad S_{11} = S_x C_x + S_y C_y + S_z C_z$$

$$2\text{-}1: \quad S_{21} = S_z C_x + S_x C_y + S_y C_z$$

$$3\text{-}1: \quad S_{31} = S_y C_x + S_z C_y + S_x C_z$$

The solution of this system of equations is:

$$S_x = -\frac{-C_x^2 S_{11} + C_y C_z S_{11} - C_y^2 S_{21} + C_x C_z S_{21} + C_x C_y S_{31} - C_z^2 S_{31}}{C_x^3 + C_y^3 + C_z^3 - 3 C_x C_y C_z} \tag{48}$$

$$S_y = -\frac{-C_y^2 S_{11} + C_x C_z S_{11} + C_x C_y S_{21} - C_z^2 S_{21} - C_x^2 S_{31} + C_y C_z S_{31}}{C_x^3 + C_y^3 + C_z^3 - 3 C_x C_y C_z} \tag{49}$$

$$S_z = -\frac{C_x C_y S_{11} - C_z^2 S_{11} - C_x^2 S_{21} + C_y C_z S_{21} - C_y^2 S_{31} + C_x C_z S_{31}}{C_x^3 + C_y^3 + C_z^3 - 3 C_x C_y C_z} \tag{50}$$

Of course, here again, increasing the number of measurements and averaging the results reduces the measurement error. The simplest increase is the doubling of the number of measurements in which each of the vectors $\vec{S}_x$, $\vec{S}_y$ and $\vec{S}_z$ from Figures 3(1-1), 4(2-1) and 5(3-1) is reversed (rotated by 180 °), new equations (1-1) to (1-3) are solved, so the newly obtained solutions (48) to (50) are averaged with the previous solutions.

Measurement of directional cosines of the magnetic field of Magnet

Alternatively, once a Sensor is calibrated as described above in the first two calibration sub-processes, it can be used to calibrate other Magnets in a simplified procedure, with at least 3 Positions. The corresponding sub-process and equations are analogous to those of the previous section "Measurement of the Sensor's magnetic sensitivity vector when the field vector of the Magnet is known".

Measurement of magnetic sensitivity vector components of multi-axial magnetic field sensors

Some magnetic sensors contain 2 or 3 directional magnetic sensors placed in a common housing or on a common semiconductor chip. Typically, each of these Sensors is directed approximately parallel to one of the 3 axes of the orthogonal coordinate system of the common sensor housing.

According to the present invention, the measurement of offsets and sensitivity vector components of such 2-axial or 3-axial Sensors is reduced to the measurement of the offset and sensitivity vector components of each of the Sensors in the housing individually, in the same way as shown above for one single-axis Sensor.

For example, if the sensitivity vector components of a 3-axial Sensor are to be measured, then Equation (14) can be written for each single-axis Sensor in the housing:

$$S_{1i} = S_{1x}C_x + S_{1y}C_y + S_{1z}C_z$$
$$S_{2i} = S_{2x}C_x + S_{2y}C_y + S_{2z}C_z \tag{51}$$
$$S_{3i} = S_{3x}C_x + S_{3y}C_y + S_{3z}C_z$$

The symbols $S_{1i}$, $S_{2i}$, $S_{3i}$ are the actual sensitivities of sensors 1, 2, 3 (i.e. sensors directed in the direction of the x, y, z axes). $C_x$, $C_y$ and $C_z$ are the cosines of the directions of the vector $\vec{B}$ in the common reference coordinate system R.

Each of these equations has the same form and meaning as equation (14), which means that the determination of the coefficients in these equations could be performed in the same way as described above for a single-axial Sensor. The only difference is that now in each Sensor-Magnet Position three voltages should be read (from the output of each of the three Sensors), not just one; and write and solve three systems of equations instead of only one.

If the magnetic field of the calibrating magnet is known, then all the sensitivity vectors of a 3-axis magnetic sensor can be determined in the sub-process described above, which comprises measurements in only 3 positions.

Measuring device

A mechanical device that defines the reference (R) coordinate system, which is common to both the vector $\vec{S}$ (i.e. to the probe housing in its basic position) and vector $\vec{B}$ should be placed in the magnet (or Helmholtz coils). This device should also enable accurate placement of the probe housing in such positions that the coordinate axes of the probe $X_s$, $Y_s$, $Z_s$ are strictly parallel to the coordinate axes of the reference system $X_r$, $Y_r$, $Z_r$, and any axis of the probe (system S) with any axis system R. The center of the field sensitive volume (FSV) of the probe should always remain in the same place, in order to be always exposed to the same vector of field $\vec{B}$.

The calibration tool does not necessarily have to be in the shape of a cube, but should enable precise rotation by 90 ° for all three angles of rotation (angles roll, pitch, yaw in Figure 4).

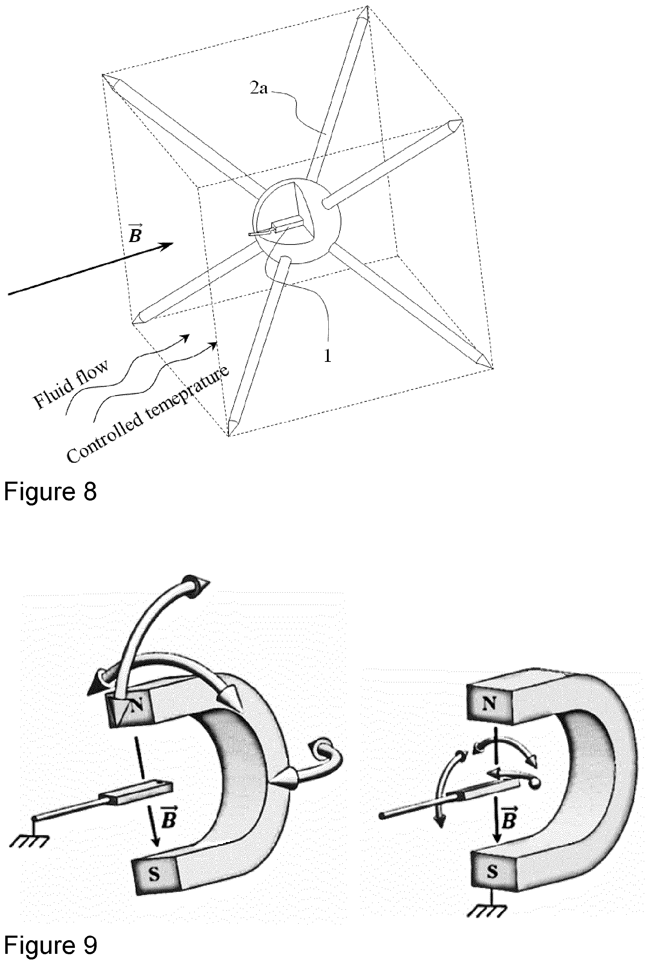

An example of one such tool is shown in Figure 8. In this example, instead of leaning on the entire surface, leaning is done on three spikes. In addition, the probe under calibration has open access which allows the flow of fluid of a certain temperature around the sensor, and this can be important when determining the temperature characteristics of the output signal offset.

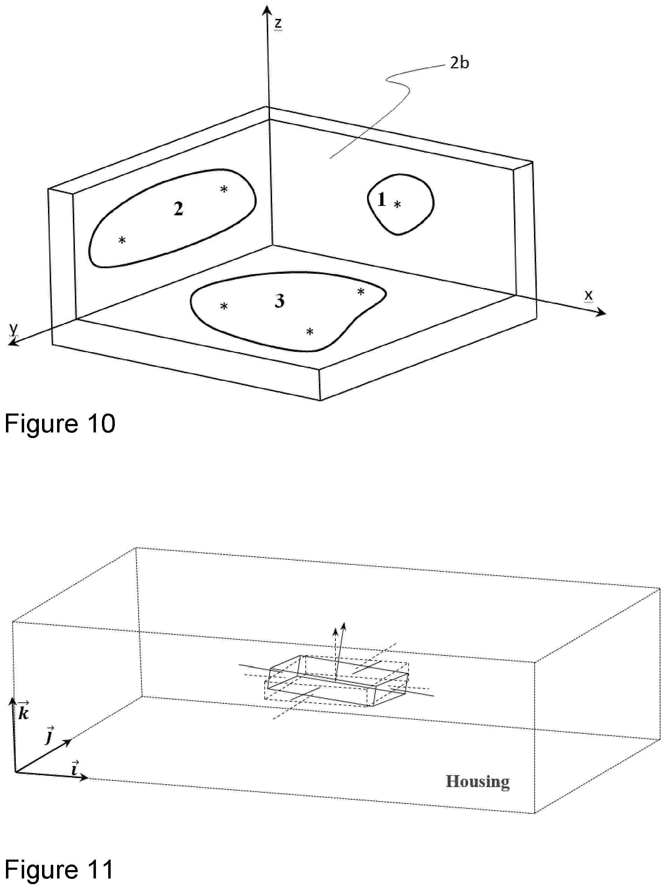

As a reminder, the same measurement results can be obtained by rotating the magnetic sensor in a constant magnetic field or by rotating the field while the magnetic sensor maintains a constant position (see Figure 10). If the field is rotated, then the source of the magnetic field is placed in a movable calibration tool, and the sensor is stationary or, after the rotation, is reset to its original set position.

The positioning of the tool from Figure 9 in the known three-dimensional Cartesian coordinate system R can be achieved with the help of a 3D corner (locator) as shown in the Figure 11.

In order for the cube to be able to rotate 90 ° in any direction and for its center of mass to always maintain the same position, it is necessary to ensure a precise locating of the cube. A 3D corner tool is used for this, or locating in the so-called. 6 points (3-2-1 location) (see Figure 11).

Exemplary embodiments

1. Method for calibrating a directional magnetic field sensor (Sensor) and calibrating magnet (Magnet), in which the module of the magnetic field of Magnet is optionally measured, Sensor and Magnet are placed relative to each other in a number of angular Positions, and at each of these Positions the output voltage of the Sensor (Voltage) is measured, comprising:
at least 7 Positions that can be obtained from each other by rotating the Sensor or Magnet about one of the axes of their common coordinate system for an pre-determined angle, each measured Voltage is substituted in the corresponding equation relating the Voltage to the offset, the components the sensitivity vector of the Sensor, and to the magnetic field of the Magnet for a given position, which leads to a system of 7 independent equations, the solution of which gives the values of the offset, the components of the magnetic sensitivity vector of the Sensor and the directional cosines of the magnetic field vector of Magnet.

2. Method according to embodiment 1, which is optimized for the measurement of Sensor's offset so that
the Sensor is placed with respect to the coordinate system of Earth or another source of magnetic field in at least 4 angular positions that are chosen so that in the resulting system of 4 independent equations the terms containing the components of the magnetic field mutually cancel, and the system reduces to a single equation, which gives the value of the sensor offset.

3. The method according to embodiment 1, which is optimized for the measurement of the components of the magnetic sensitivity vector of the Sensor and of the directional cosines of the magnetic field vector of Magnet, Comprising

> Measurement of the module of the magnetic field of Magnet
> At least 6 Positions that are chosen so that the resulting system of 6 independent equations is analytically solvable, the solutions give
> both the values of the components of the magnetic sensitivity vector of Sensor and the values of the directional cosines of the magnetic field vector of the Magnet.

4. The method according to embodiment 3, optimized for the measurement of only the components of the magnetic sensitivity vector of the Sensor, whereas the directional cosines the magnetic field vector of Magnet are known comprising:

> that the Sensor is positioned respect to the coordinate system of the Magnet,
> or the Magnet is positioned respect to the coordinate system of the Sensor,
> in at least 3 Positions,
> resulting in a system of 3 equations,
> and by solving this system of equations,
> the values of the components of the magnetic sensitivity vector of the Sensor are obtained.

5. Method for calibrating a two-axis or three-axis magnetic field sensor (Sensor), consisting of 2 or 3 mutually orthogonally-oriented single-axis sensors, which are integrated on the same semiconductor chip or packed in the same housing, comprising:
the same procedure according to Embodiment 4, wich is applied in parallel to each of these single-axis sensors.

6. Method according to embodiments 1 - 5:
that it can be used for calibration of Hall effect sensors, magneto-resistors, flux-gates, and pick-up coils.

7. The calibration method according to embodiments 1 - 5, comprising:
may have as its source a magnetic field vector, permanent magnet or a combination of permanent magnets, or an Earth's magnetic field, or electric magnetic field sources such as an electromagnet, coil, coil combination all supplied with direct and / or alternating current.

8. Device for calibration of magnetic sensors, comprising:

> a housing (2a and 2b) that provides a precise angular rotation of 90 ° relative to the Magnet, and
> contains a magnetic sensor inside that provides a defined position of the magnetic sensor relative to the reference plane of the housing, and allows change and temperature stabilization of the magnetic sensor.

9. The device according to embodiment 8, comprising a cuboid body, which can be placed in a suitable corner in up to 24 positions.

10. The calibration method according to embodiment 1, can be analogously applied to the calibration of any vector sensor in a suitable vector field, for example, an electric field, a gravitational field, and the like.

11. The calibration method according to embodiment 1, comprising
a body with sides corresponding to one of the regular polyhedra which is rotated in the corresponding corner for angular positioning, thus obtaining a system of equations whose solution is simplified.

12. The calibration procedure according to embodiments 1 and 2, when offset calibration is performed, the icosahedron approach can be used for precise angular positioning.

13. The calibration procedure according to embodiment 1, can be applied analogously (extended) to the calibration of a 1D, 2D or 3D array of magnetic vector sensors, in a suitable homogeneous magnetic field by applying to each field element independently.

14. The calibration process according to embodiments 1 or 2 may use an already known rotation device, for example a robotic arm.

Figure 4 illustrates a Cartesian coordinate system with Euler's angles of rotation: roll, pitch and yaw.

Figure 8 shows an example of a cuboid body used in offset calibration and magnetic sensitivity calibration.

Figure 9 illustrates Invariance of offset calibration and magnetic sensitivity calibration with respect to Sensor rotation or Magnet rotation.

Figure 10 shows a part of the calibration tool in the form of a 3D corner for precise rotation of the cuboid body from Figure 8.

Figure 11 shows magnetic sensor (e.g. a Hall plate) in its housing.

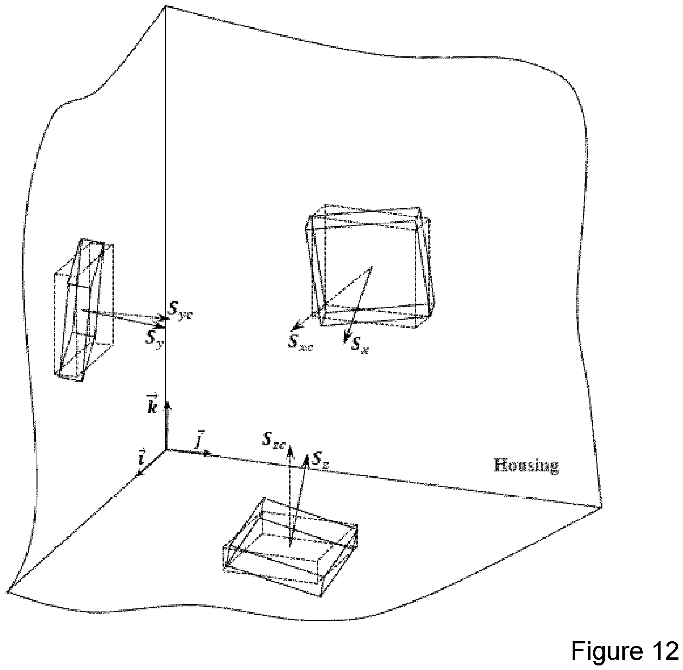

Figure 12 shows three magnetic sensors (e.g. three Hall plates) in a common housing.

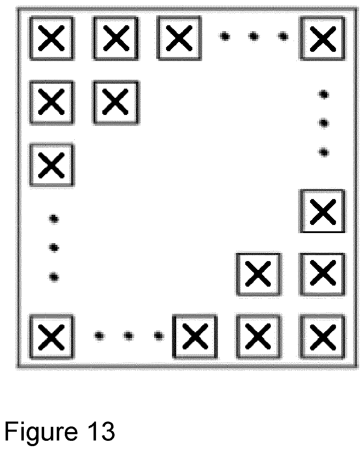

Figure 13 shows a 2D Hall sensors array

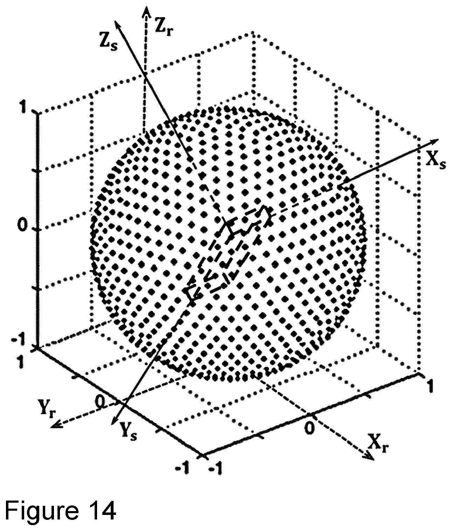

Figure 14 shows a unit sphere with points evenly distributed over the surface using the icosahedron approach

This description and any accompanying drawings that illustrate aspects and embodiments of the present invention should not be taken as limiting the claims defining the protected invention. In other words, while the invention has been illustrated and described in detail in the drawings and foregoing description, such illustration and description are to be considered illustrative or exemplary and not restrictive. Various mechanical, compositional, structural, electrical, and operational changes may be made without departing from the spirit and scope of this description and the claims. In some instances, well-known circuits, structures and techniques have not been shown in detail in order not to obscure the invention. Thus, it will be understood that changes and modifications may be made by those of ordinary skill within the scope and spirit of the following claims. In particular, the present invention covers further embodiments with any combination of features from different and/or individual embodiments as described above and below. Embodiments in accordance with the invention may, in particular, include further and/or additional features, elements, aspects, etc. not shown in the drawings or described above.

The disclosure also covers all further features shown in any Figure, individually, although they may not have been described in the afore or following description. Also, individual alternatives of the embodiments described in any Figure and the description and individual alternatives of features thereof can be disclaimed from the subject matter of the invention or from disclosed subject matter. The disclosure comprises subject matter consisting of the features defined in the claims or the exemplary embodiments as well as subject matter comprising said features.

The present disclosure also includes embodiments with any combination of features which are mentioned or shown above and/or below, in various embodiments or variants. It also includes individual features as shown in the Figures, even if they are shown there in connection with other features and/or are not mentioned above or below. The disclosure comprises embodiments which exclusively comprise the features described in the claims or the exemplary embodiments, as well as those which comprise additional other features. The steps of any method disclosed above or claimed below may preferably be carried out according the order in which they are presented, but may also be carried out in a different order.

Furthermore, in the claims the word "comprising" does not exclude other elements or steps, and the indefinite article "a" or "an" does not exclude a plurality. A single unit or step may fulfil the functions of several features recited in the claims. The mere fact that certain measures are recited in mutually different dependent claims does not indicate that a combination of these measures cannot be used to advantage. The terms "essentially", "substantially", "about", "approximately" and the like in connection with an attribute or a value particularly also define exactly the attribute or exactly the value, respectively. The term "about" in the context of a given numerate value or range refers to a value or range that is, e.g., within 20%, within 10%, within 5%, or within 2% of the given value or range. Components described as coupled or connected may be electrically or mechanically directly coupled, or they may be indirectly coupled via one or more intermediate components. Any reference signs in the claims should not be construed as limiting the scope.

## Claims

1. A method for calibrating a magnetic sensor and/or a calibrating magnet, said sensor, when subjected to a magnetic field $\vec{B} = (B_x; B_y; B_z)^T$ exhibiting an output voltage $V$ governed by $V = V_0 + \vec{S} \cdot \vec{B}$, wherein $V_0$ denotes an offset voltage of the magnetic sensor, and $\vec{S} \cdot \vec{B}$ denotes a scalar product of a sensitivity vector $\vec{S} = (S_x; S_y; S_z)^T$ of the magnetic sensor and the magnetic field vector $\vec{B}$, the method comprising the steps of

a. measuring a first output voltage $V_1$, for a first orientation of the magnetic sensor relative to the magnetic field;

b. rotating the magnetic sensor relative to the magnetic field to assume $N$-1 further orientations, wherein $2 \leq N \in \mathbb{N}$ and each orientation is defined by a rotation matrix $\overleftrightarrow{R}_n$, wherein $\overleftrightarrow{R}_n \neq \overleftrightarrow{1}$ for $n \in \{2, ..., N\}$ and $\overleftrightarrow{R}_n \neq \overleftrightarrow{R}_m$ for $n \neq m \in \{2, ..., N\}$;

c. for each further orientation, measuring one further output voltage $V_n$, with $n \in \{2; ...; N\}$; and

d. solving a system of N equations $V_n = V_0 + (\overleftrightarrow{R}_n \vec{S}) \cdot \vec{B}$ with $\overleftrightarrow{R}_1 = \overleftrightarrow{1}$ for one or more of $V_0, S_x, S_y, S_z, B_x, B_y$, and/or $B_z$.

2. The method of claim 1, wherein

    a. $N = 4$;

    b.

$$\overleftrightarrow{R}_2 = \begin{pmatrix} -1 & 0 & 0 \\ 0 & -1 & 0 \\ 0 & 0 & 1 \end{pmatrix}, \overleftrightarrow{R}_3 = \begin{pmatrix} -1 & 0 & 0 \\ 0 & 1 & 0 \\ 0 & 0 & -1 \end{pmatrix}, \overleftrightarrow{R}_4 = \begin{pmatrix} 1 & 0 & 0 \\ 0 & -1 & 0 \\ 0 & 0 & -1 \end{pmatrix};$$

    and

    c. the system of equations is solved for $V_0$, in particular according to

$$V_0 = (V_1 + V_2 + V_3 + V_4)/4 \ .$$

3. The method of claim 1, wherein

    a. $N = 6$;

    b. $B = \|\vec{B}\|$ is measured using a magnetometer, in particular using an NMR teslameter;

$$B = \sqrt{B_x^2 + B_y^2 + B_z^2}$$

    c. an additional equation      is added to the system of 6 equations;

    d. the system of equations is solved for $V_0, S_x, S_y, S_z, B_x, B_y$, and/or $B_z$, in particular numerically.

4. The method of claim 1, further comprising the steps of

    a. determining a vector $\vec{D}$ with $\|\vec{D}\| \neq 0$ and $\vec{D} \cdot \vec{B} = 0$ or $\vec{D} \cdot \vec{S} = 0$;

    b. after measuring the first output voltage $V_1$, rotating the sensor or the magnetic field by 180° or -180° about $\vec{D}$;

    c. measuring the second output voltage $V_2$;

    d. solving the system of equations

       i.

$$V_1 = V_0 + \vec{S} \cdot \vec{B}$$

       ii.

$$V_2 = V_0 - \vec{S} \cdot \vec{B}$$

    analytically, in particular according to   $V_0 = \dfrac{(V_1 + V_2)}{2}$ .

5. The method of claim 2, further comprising the steps of

    a. measuring $B = \|\vec{B}\|$ using a magnetometer, in particular using an NMR teslameter;

    b. positioning the sensor in a first orientation relative to the magnetic field, in particular with x-, y- and z-axes of the sensor parallel to X-, Y-, and Z-axes, respectively, of a magnet providing the magnetic field $\vec{B}$;

i. determining a first actual sensitivity $S_{11}$ from the output voltage $V$ for the first orientation according to $S_{11} = (V - V_0) / B$

ii. rotating the magnetic sensor relative to the magnetic field to assume second, third, and fourth orientations rotated by 90°, 180° and 270°, respectively, about the x-axis relative to the first position

iii. determining a second, third and fourth actual sensitivity S12, $S_{13}$, $S_{14}$ according to $S_{12} = (V - V_0) / B$, $S_{13} = (V - V_0) / B$, $S_{14} = (V - V_0) / B$ from the respective output voltages $V$ for the second, third, and fourth orientations;

iv. calculating $S_{1x} = 4S_x C_x$, wherein $C_x = B_x/B$ according to $S_{1x} = S_{11} + S_{12} + S_{13} + S_{14}$,

c. positioning the sensor in a fifth orientation relative to the magnetic field, in particular with the x-, y- and z-axes of the sensor parallel to the Y-, Z-, and X-axes, respectively, of the magnet,

i. determining a fifth actual sensitivity $S_{21}$ from the output voltage $V$ for the fifth orientation according to $S_{21} = (V - V_0) / B$,

ii. rotating the magnetic sensor relative to the magnetic field to assume sixth, seventh and eighth orientations rotated by 90°, 180° and 270°, respectively, about the y-axis relative to the fifth position,

iii. determining sixth, seventh and eighth actual sensitivities $S_{22}$, $S_{23}$, $S_{24}$ according to $S_{22} = (V - V_0) / B$, $S_{23} = (V - V_0) / B$, $S_{24} = (V - V_0) / B$ from the respective output voltages $V$ for the sixth, seventh and eighth orientations;

iv. calculating $S_{2x} = 4S_x C_y$, wherein $C_y = B_y/B$ according to $S_{2x} = S_{21} + S_{22} + S_{23} + S_{24}$;

d. positioning the sensor in a ninth orientation relative to the magnetic field, in particular with the x-, y- and z-axes of the sensor parallel to the Z-, X-, and Y-axes, respectively, of the magnet,

i. determining a ninth actual sensitivity $S_{31}$ from the output voltage $V$ for the ninth orientation according to $S_{31} = (V - V_0) / B$,

ii. rotating the magnetic sensor relative to the magnetic field to assume tenth, eleventh and twelfth orientations rotated by 90°, 180° and 270°, respectively, about the y-axis relative to the ninth position,

iii. determining tenth, eleventh and twelfth actual sensitivities $S_{32}$, $S_{33}$, $S_{34}$ according to $S_{32} = (V - V_0) / B$, $S_{33} = (V - V_0) / B$, $S_{34} = (V - V_0) / B$ from the respective output voltages $V$ for the tenth, eleventh and twelfth orientations;

iv. calculating $S_{3x} = 4S_x C_z$, wherein $C_z = B_z/B$ according to $S_{3x} = S_{31} + S_{32} + S33 + S_{34}$;

e. calculating $S_x$ according to $$S_x = (1/4)\sqrt{S_{1x}^2 + S_{2x}^2 + S_{3x}^2}$$ ;

f. calculating $C_x$, $C_y$, $C_z$, representing cosines of the direction of the magnetic field vector $\vec{B}$, according to

i.

$$C_x = S_{1x} / (4S_x);$$

ii.

$$C_y = S_{2x} / (4S_x);$$

iii.

$$C_z = S_{3x} / (4S_x).$$

**6.** The method of claim 5, further comprising the steps of

a. calculating $S_y$ according to $$S_y = \frac{2(S_{22} - S_{24} + S_{31} - S_{33}) + (C_z - C_y)(S_{21} - S_{23} - S_{32} + S_{34})}{8C_x^2 + 2C_y^2 - 4C_y C_z + 2C_z^2}$$ ;

b. calculating $S_z$ according to

$$S_z = \frac{2C_x(S_{21}-S_{23}+S_{34}-S_{32})+(C_z-C_y)(S_{24}-S_{22}+S_{33}-S_{31})}{2(4C_x^2+C_y^2-2C_yC_z+C_z^2)}.$$

7. The method of claim 5, further comprising the steps of

    a. orientating a further sensor so that its sensitivity components $S_x$, $S_y$ and $S_z$ are, one after the other, parallel to the main component of the vector $\vec{B}$, for example, parallel to $B_x$; and/or with its x-, y- and z-axes successively parallel to the X-axis of the magnet;

    b. determining actual sensitivities $S_{12}$, $S_{21}$, $S_{31}$ for the further sensor from the respective output voltage $V$ exhibited by the further sensor for each of the respective orientations;

    c. calculating sensitivity components $S_x$, $S_y$, $S_z$ according to

        i.

$$S_x = -\frac{-C_x^2 S_{11}+C_yC_z S_{11}-C_y^2 S_{21}+C_xC_z S_{21}+C_xC_y S_{31}-C_z^2 S_{31}}{C_x^3+C_y^3+C_z^3-3C_xC_yC_z};$$

        ii.

$$S_y = -\frac{-C_y^2 S_{11}+C_xC_z S_{11}+C_xC_y S_{21}-C_z^2 S_{21}-C_x^2 S_{31}+C_yC_z S_{31}}{C_x^3+C_y^3+C_z^3-3C_xC_yC_z};$$

        and
        iii.

$$S_z = -\frac{C_xC_y S_{11}-C_z^2 S_{11}-C_x^2 S_{21}+C_yC_z S_{21}-C_y^2 S_{31}+C_xC_z S_{31}}{C_x^3+C_y^3+C_z^3-3C_xC_yC_z}.$$

8. The method of any preceding claim, further comprising

    a. providing a second magnetic sensor having both a fixed position and orientation relative to the first magnetic sensor;

    b. said second magnetic sensor exhibiting an output voltage $^2V$ governed by $^2V = {^2V_0} + \overrightarrow{^2S} \cdot \vec{B}$, wherein $^2V_0$ denotes an offset voltage of the second magnetic sensor, and $\overrightarrow{^2S} \cdot \vec{B}$ denotes a scalar product of a sensitivity vector $\overrightarrow{^2S} \cdot = ({^2S_x}; {^2S_y}; {^2S_z})^\mathsf{T}$ of the second magnetic sensor and the magnetic field vector $\vec{B}$;

    c. for each of the N orientations, measuring an output voltage $^2V_n$ of the second sensor with $n \in \{1; ...; N\}$;

    d. solving a system of 2N equations $V_n = V_0 + (\vec{R}_n \, \overline{S}) \cdot \vec{B}$, $^2V_b = {^2V_0} + (\vec{R}_n \, \overrightarrow{^2S}) \cdot \vec{B}$ with $\vec{R}_1 = \vec{1}$ for one or more of $V_0$, $S_x$, $S_y$, $S_z$, $^2V_0$, $^2S_x$, $^2S_y$, $^2S_z$, $B_x$, $B_y$, and/or $B_z$.

9. The method of claim 8, wherein

    a. $N= 5$;

    b. $B = ||\vec{B}||$ is measured using a magnetometer, in particular using an NMR teslameter;

$$B = \sqrt{B_x^2 + B_y^2 + B_z^2}$$

    c. an additional equation      is added to the system of 6 equations;

    d. the system of equations is solved for $V_0$, $S_x$, $S_y$, $S_z$, $^2V_0$, $^2S_x$, $^2S_y$, $^2S_z$, $B_x$, $B_y$, and/or $B_z$, in particular analytically.

10. The method of claim 8 or 9, further comprising:

    a. providing a third magnetic sensor having both a fixed position and orientation relative to each of the first and the second magnetic sensor;

b. said third magnetic sensor exhibiting an output voltage $^3V$ governed by $^3V = {}^3V_0 + \overrightarrow{^3S} \cdot \vec{B}$, wherein $^3V_0$ denotes an offset voltage of the third magnetic sensor, and $\overrightarrow{^3S} \cdot \vec{B}$ denotes a scalar product of a sensitivity vector $\overrightarrow{^3S} \cdot = ({}^3S_x; {}^3S_y; {}^3S_z)^T$ of the third magnetic sensor and the magnetic field vector $\vec{B}$;

c. for each of the N orientations, measuring an output voltage $^3V_n$ of the third sensor with $n \in \{1; ...; N\}$;

11. The method of claim 10, wherein:

a. N= 5;

b. the system of equations is solved for $V_0$, $S_x$, $S_y$, $S_z$, $^2V_0$, $^2S_x$, $^2S_y$, $^2S_z$, $^3V_0$, $^3S_x$, $^3S_y$, $^3S_z$, $B_x$, $B_y$, and/or $B_z$, in particular analytically.

12. The method of any preceding claim, further comprising:

a. mounting the magnetic sensor or a sensor module comprising said sensor on a rigid body in a defined, constant position,

b. said rigid body configured to

i. be placed onto a support, in particular a flat surface,

ii. rest stably on the support surface in a number of different orientations; wherein

iii. the rigid body preferably has and/or defines a surface corresponding to a cuboid, in particular a rectangular cuboid.

13. The method of claim 12 or 13, further comprising

a. mounting a second magnetic sensor on the rigid body in a defined, constant second position: and

b. optionally mounting a third magnetic sensor on the rigid body in a defined, constant third position.

14. The method of any preceding claim, further comprising:

a. determining components of the sensitivity vector or vectors, in particular $S_x$, $S_y$, $S_z$, $^2S_x$, $^2S_y$, $^2S_z$, $^3S_x$, $^3S_y$ and/or $^3S_z$, with respect to a natural coordinate system of the first sensor and/or a package comprising the first sensor, and preferably the second and/or third sensors.

15. The method of claim 14, further comprising

a. storing components of the sensitivity vector or vectors, in particular with respect to a natural, coordinate system of the first sensor and/or a package comprising the first sensor, in a volatile memory comprised by electric and/or electronic circuitry comprising and/or comprised by the sensor, and preferably enclosed in the package comprising the first sensor.

Figure 1

Figure 2

Figure 3

Figure 4

Figure 5

Figure 6

Figure 7

Figure 8

Figure 9

Figure 10

Figure 11

Figure 12

Figure 13

Figure 14

Europäisches
Patentamt

European
Patent Office

Office européen
des brevets

# EUROPEAN SEARCH REPORT

**Application Number**

EP 22 02 0110

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 315 983 A1 (SENIS AG [CH]) 2 May 2018 (2018-05-02) | 1-4, 12-15 | INV. G01R33/00 G01R33/07 G01R35/00 |
| A | * paragraphs [0040] - [0051]; figures 1-12 * | 5-7 | |
| X | WOUTERS C ET AL: "Calibration scheme for a new type of 3D Hall sensor", SENSORS AND ACTUATORS A: PHYSICAL, vol. 257, 7 February 2017 (2017-02-07), pages 38-46, XP029944931, ISSN: 0924-4247, DOI: 10.1016/J.SNA.2017.02.007 | 1-4,8-15 | ADD. G01R33/02 |
| A | * sections 2.1 and 2.2; figures 1-3 * | 5-7 | |

**TECHNICAL FIELDS SEARCHED (IPC)**

G01R
G01C

The present search report has been drawn up for all claims

| Place of search | Date of completion of the search | Examiner |
|---|---|---|
| Munich | 29 August 2022 | Philipp, Peter |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.......................................................................

& : member of the same patent family, corresponding
document

EPO FORM 1503 03.82 (P04C01)

## EP 4 246 164 A1

### ANNEX TO THE EUROPEAN SEARCH REPORT
### ON EUROPEAN PATENT APPLICATION NO.

EP 22 02 0110

29-08-2022

| Patent document cited in search report | | Publication date | Patent family member(s) | | Publication date |
|---|---|---|---|---|---|
| EP 3315983 | A1 | 02-05-2018 | CN 108008330 | A | 08-05-2018 |
| | | | EP 3315983 | A1 | 02-05-2018 |
| | | | JP 7067764 | B2 | 16-05-2022 |
| | | | JP 2018072332 | A | 10-05-2018 |
| | | | US 2018120406 | A1 | 03-05-2018 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1518131 A1